# EUROPEAN PATENT APPLICATION

(11) **EP 4 465 346 A1**
(43) Date of publication of application: **20.11.2024**
(21) Application number: 23173996.2
(22) Date of filing: 17.05.2023
(51) Int. Cl.: H01L 23/00

(54) **BOND PAD DESIGN FOR SEMICONDUCTOR DEVICE PACKAGES**

(71) Applicant: Nexperia B.V., 6534 AB Nijmegen (NL)
(72) Inventor: VADDAGARE, Nagaraju Vasantha Kumar, Hamburg (DE); RITTER, Hans-Martin, 22529 Hamburg (DE); HOLLAND, Steffen, 22529 Hamburg (DE); BURMEISTER, Frank, Hamburg (DE)
(74) Representative: Pjanovic, Ilija

(57) **Abstract**

A DSN, semiconductor device package, wherein the bond pad to the terminal includes an additional area in the second metallization layer, which is rectangularly shaped and extends from one side, e.g., the middle, of the terminal towards a location above the semiconductor device.

## Description

### Technical field

The present disclosure relates to semiconductor device packages, and in particular to bond pad designs of semiconductor device packages.

### Background

A dual silicone no-lead (DSN) semiconductor device package is a type of surface-mount semiconductor packaging technology used to connect and protect semiconductor devices. A DSN semiconductor device package has contact terminals on the bottom, which may be used to connect the DSN package to a printed circuit board (PCB) or other electronic component. The contact terminals are typically placed closer to the edges of the DSN semiconductor device package, while the semiconductor device is typically placed closer to the center of the DSN semiconductor device package and in between the terminals. Depending on the type of semiconductor device, there may be two or more terminals on the outside of the DSN semiconductor device package. A bond pad layer above the layers defining the semiconductor device typically provides the terminals, which are typically substantially rectangularly shaped.

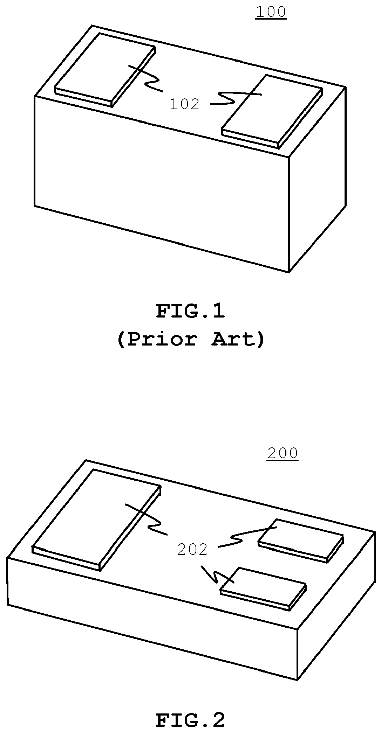

An example of a DSN diode 100 is shown in Fig. 1, with two terminals 102 on the bottom side of the DSN semiconductor device package. Terminals 102 may have, e.g., a length of 0.275 mm to 0.325 mm and a width of 0.13 mm to 0.15 mm, with the center of the terminals being spaced apart 0.4 mm. An example of a DSN metal-oxide-semiconductor field-effect transistor (MOSFET) 200 is shown in Fig. 2, with three terminals 202 on the bottom side of the DSN semiconductor device package.

Electrostatic discharge (ESD) protection is an important aspect of semiconductor device packages, such as DSN semiconductor device packages. ESD protection devices, which are typically implemented between the terminals and the semiconductor device withing the DSN semiconductor device package, preferably have low capacitance and low clamping voltages at the same time. A large capacitance can hamper data transfer and high clamping voltage can destroy the semiconductor device to be protected. High speed interfaces tolerate very little additional capacitance on the line, however miniaturization makes them increasingly sensitive to ESD strikes. Bond pad capacitance and interconnect capacitance disadvantageously adds to the total capacitance of the ESD protection device.

### Summary

The present disclosure provides an improved bond pad design for semiconductor device packages and is particularly advantageous for application in DSN semiconductor device packages. The solution of the present disclosure may provide the same solder footprint and terminal dimensions as known DSN packages in order to comply with industry standards. Advantageously, the bond pad design of the present disclosure reduces the total overall capacitance and clamping voltages.

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

According to an aspect of the present disclosure, a semiconductor device package is presented. The semiconductor device package may include a bond pad defined by a first set of layers and a semiconductor device defined by a second set of layers. The bond pad may provide a terminal of the semiconductor device package. The first set of layers may include a first metallization layer exposing the bond pad to the outside of the semiconductor device package. The first metallization layer may include a first area in the plane of the first metallization layer. The first area may at least include a rectangularly shaped area. The first area may include a first metal. The first set of layers may further include a second metallization layer that is conductively connected to the first metallization layer. The second metallization layer may include a second area in the plane of the second metallization layer. The second area may be positioned below the first area. The second area may include a second metal. The second metallization layer may further include a third area in the plane of the second metallization layer. The third area may be rectangularly shaped and may extend from one side of the second area towards a location above the semiconductor device. The width of the third area where the third area touches the one side of the second area may be smaller than the length of the one side of the second area. The third area may include the second metal.

The third area may be rectangularly shaped and may extend from the middle of one side of the second area towards a location above the semiconductor device.

The second area and the third area may form one area of second metal.

The rectangularly shaped area of the first area may provide a terminal complying with industry standards.

It will be understood that the rectangularly shaped area may be substantially rectangular. For example, irregularities in the shape due to the manufacturing process and rounded corners are allowed.

Similarly, the rectangular shape of the third area may be substantially rectangular.

The expressions 'below' and 'above' in the context of layers are to be understood to indicate a relative position of the layers, where the highest layer corresponds to the first metallization layer and the second set of layers defining the semiconductor device is typically positioned below the first set of layers defining the bond pad.

The expression 'towards a location above' is to be understood to indicate a direction within a layer; it is not meant to indicate an extension as far as the location above.

In an embodiment, the second area and the third area may be fully covered by the first area.

In another embodiment, the second area may be fully covered by the first area and the third area may be not covered by the first area.

The expression 'covered' in the context of areas in different layers is to be understood to indicate that an area in a higher layer is positioned above an area in a lower layer. The shape of the areas may be different, but the area in the higher layer is at least similar in shape or larger than the area in the lower layer.

In an embodiment, the first set of layers may further include a third metallization layer providing a via between the third area of the second metallization layer and a device pad of the semiconductor device. The via may include the second metal.

In an embodiment, the first metal may be tin (Sn).

In another embodiment, the first metal may be a nickel/gold alloy (NiAu).

In another embodiment, the first metal may be a nickel/palladium/gold alloy (NiPdAu).

In an embodiment, the second metal may be copper (Cu).

In an embodiment, the width of the third area may be about one third of the length of the one side of the second area.

In an embodiment, the third area may extend from the middle of the one side of the second area to above an edge of the semiconductor device.

In an embodiment, the second metallization layer may be directly below the first metallization layer.

In another embodiment, the first set of layers may include one or more further metallization layers between and conductively connecting the first metallization layer and the second metallization layer.

In an embodiment, the semiconductor device package may include two similarly shaped bond pads each formed as the bond pad described above. The bond pads may be positioned in a mirrored orientation, such that the third area of each of the bond pads extends towards the location above the semiconductor device.

The semiconductor device package may include more than two similarly shaped bond pads each formed as the bond pad described above. Two bond pads may, e.g., be used for a DSN diode. Three bond pads may, e.g., be used for a DSN MOSFET.

In an embodiment, the first metallization layer may further include a fourth area between the first areas of the bond pads. The fourth area may include a protective, non-conductive coating.

In an embodiment, the semiconductor device package may be a DSN semiconductor device package.

According to an aspect of the present disclosure, a method of manufacturing a semiconductor device package, such as a DSN semiconductor device package, is presented. The semiconductor device package may include a bond pad defined by a first set of layers and a semiconductor device defined by a second set of layers. The bond pad may provide a terminal of the semiconductor device package. Moreover, the semiconductor device package may include any of the features described above. The method may include creating a second metallization layer of the first set of layers. The method may further include creating a first metallization of the first set of layers. The first set of layers may thus be formed having one or more of the above described features.

The first metallization layer and the second metallization layer may be created in a single step.

In an embodiment, the two similarly shaped bond pads may be created, each formed as the bond pad. The bond pads may be positioned in a mirrored orientation, the third area of each of the bond pads extending towards the location above the semiconductor device. A similar result may be achieved by having one bond pad rotated 180° relative to the other bond pad.

The method may further include using further masks to create the second set of layers. I.e., it is to be understood that further manufacturing steps may be performed to create the semiconductor device package.

### Brief description of the Drawings

Embodiments of the present disclosure will now be described, by way of example only, with reference to the accompanying schematic drawings in which corresponding reference symbol indicate corresponding parts, in which:
Fig. 1 shows a schematic 3-dimensional view of a prior art DSN diode;
Fig. 2 shows a schematic 3-dimensional view of a prior art DSN MOSFET;
Fig. 3 shows a schematic 3-dimensional view of a DSN diode of an example embodiment of the present disclosure;
Fig. 4 shows a schematic 2-dimensional view of a DSN semiconductor device package indicating areas of a bond pad of an example embodiment of the present disclosure;
Fig. 5 shows a schematic side cross-section of a DSN semiconductor device package of an example embodiment of the present disclosure;
Fig. 6 shows a legend indicating materials used in Figs. 7A-12B;
Figs. 7A, 8A, 9A, 10A, 11A, 12A and 13A show schematic 2-dimensional views of example embodiments of DSN semiconductor device packages of the present disclosure;
Figs. 7B, 8B, 9B, 10B, 11B, 12B and 13B show schematic 3-dimensional side cross-sections of example embodiments of DSN semiconductor device packages of the present disclosure;
Figs. 14A-D show schematic 2-dimensional views of example embodiments of bond pads of DSN semiconductor device packages of the present disclosure; and
Fig. 15 shows steps of a method of manufacturing a DSN semiconductor device.

The figures are intended for illustrative purposes only, and do not serve as restriction of the scope of the protection as laid down by the claims.

Where appropriate, the x/y/z orientation of the views has been indicated in the drawings.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure can be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

In the following examples DSN semiconductor device packages are shown. The present disclosure is particularly advantageous for DSN semiconductor device packages, but may be applied to other semiconductor device packages. I.e., the present disclosure is not limited to DSN semiconductor device packages.

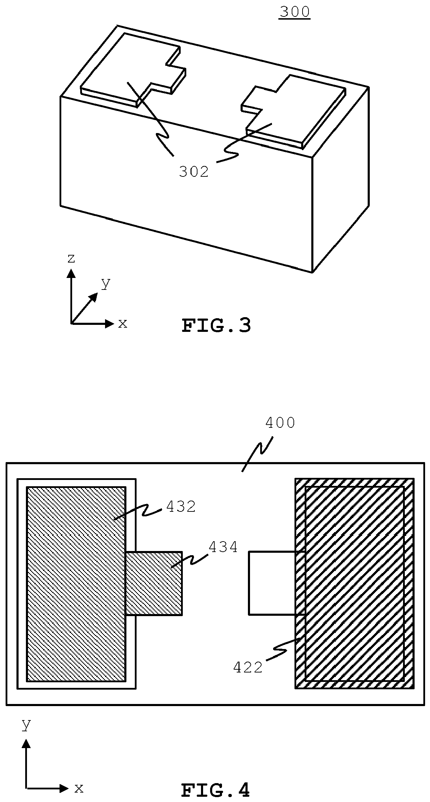

In Fig. 3 an example DSN diode 300 is shown with two terminals 302. Compared to Fig. 1, the bonds pads providing the terminals 302 have been modified by extending the metallization layers towards the middle of the DSN semiconductor package where the semiconductor device is located. DSN diode 300 includes the same solder footprint and terminal dimensions as the DSN package 100 in order to comply with industry standards. Advantageously, the bond pad design of the present disclosure reduces the total overall capacitance and clamping voltages, as will be further explained in the following.
The terminals 302 are typically located at the bottom side of the DSN diode 300, i.e., the DSN diode 300 is shown upside-down.

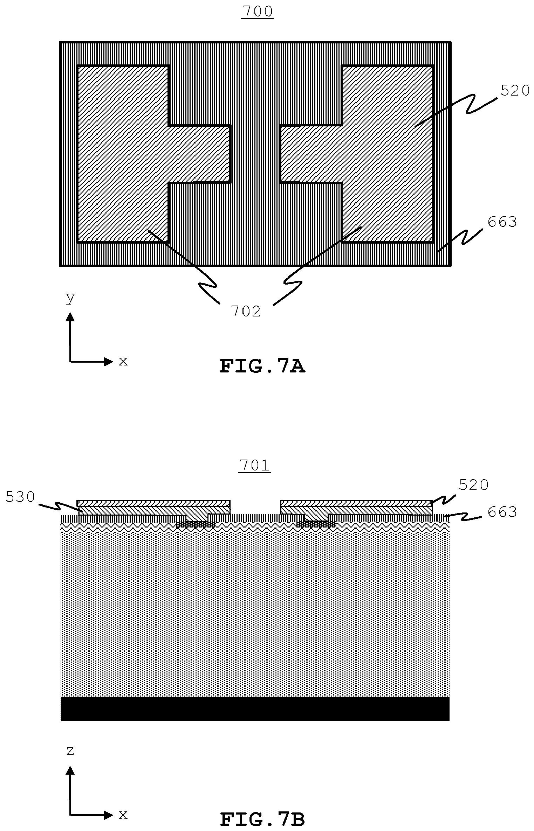

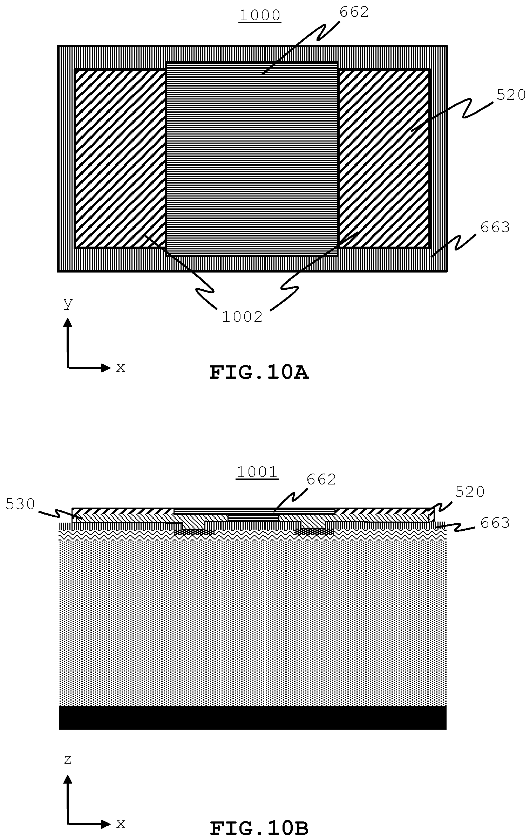

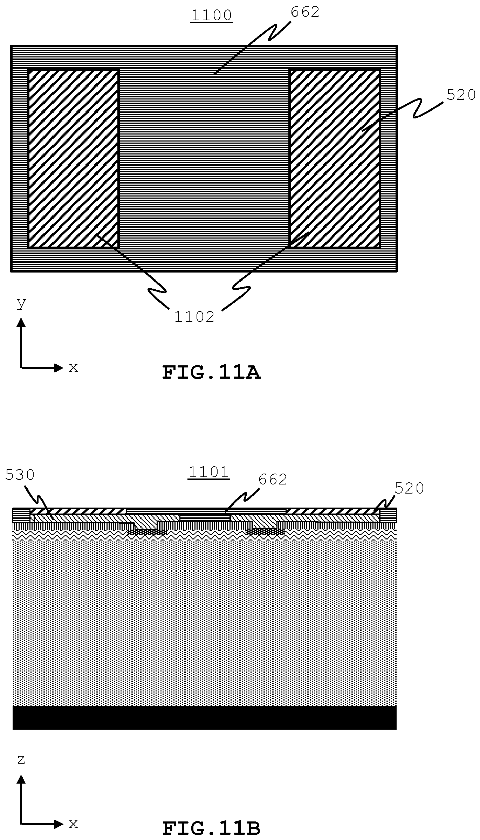

Fig. 4 shows a schematic 2-dimensional view of a DSN semiconductor device package 400 of an example embodiment, which may be similar to the DSN diode 300. In Fig. 4 different areas of metallization layers are shown. A first area 422 of a first metallization layer may be the top-most layer exposing the bond pad to the outside of the DSN semiconductor device package 400. A second area 432 and a third area 434 of a second metallization layer may be located in a layer below the first metallization layer. In the example of Fig. 4, the third area 434 is not covered by the first metallization layer, such as also shown in the example of Figs. 10A and 11A. The third area 434 may be covered by the metal of the first metallization layer, such as shown in the examples of Figs. 7B, 8B and 9B. Note that only one of the two first areas 422, second areas 432 and third areas 434 is shown in Fig. 4. The second area 432 and the third area 434 typically form one single area of same conducting material.

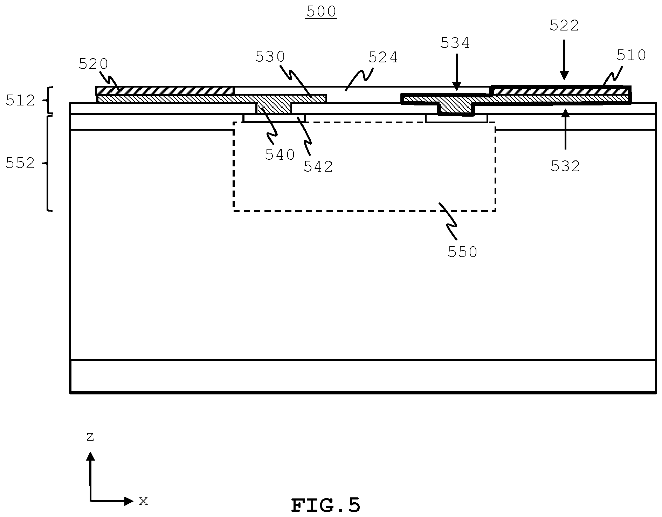

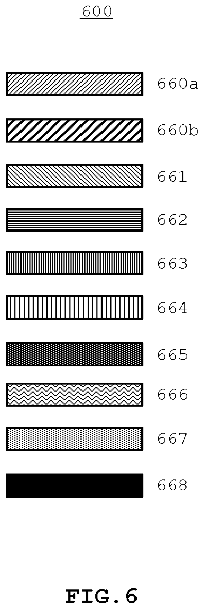

Fig. 5 shows a schematic side cross-section of a DSN semiconductor device package 500 of an example embodiment. Fig. 5 shows a layered structure of the DSN semiconductor package. More details about the various layers and its materials are shown in the example embodiments of Figs. 6-12.

In the example of Fig. 5, a bond pad 510 may be defined by a first set of layers 512. Only one of the two bond pads 510 have been identified in Fig. 5. The bond pad 510 may include a first metallization layer 520 where a first area 522 may be located, similar to first area 422. The bond pad 510 may further include a second metallization layer 530 where a second area 532 and a third area 534 may be located, similar to second area 432 and third area 434.

In the example of Fig. 5, a semiconductor device 550 may be defined by a second set of layers 552. The size of the semiconductor device 550, e.g., its width and/or depth in layers, may be different depending on the type of semiconductor device. Non-limiting examples of semiconductor devices 550 are a diode, a (power) MOSFET, a silicon controlled rectifier (SCR), and etcetera.

The bond pad 510 may be conductively connected to the semiconductor device 550 via a third metallization layer 540 and a device pad 542. The third metallization layer 540 provides, e.g., a via between the second metallization layer 530 and the device pad 542. The present disclosure is not limited to such third metallization layer 540 and device pad 542. Any other suitable implementation may be used for connecting the bond pad 510 to the semiconductor device 550.

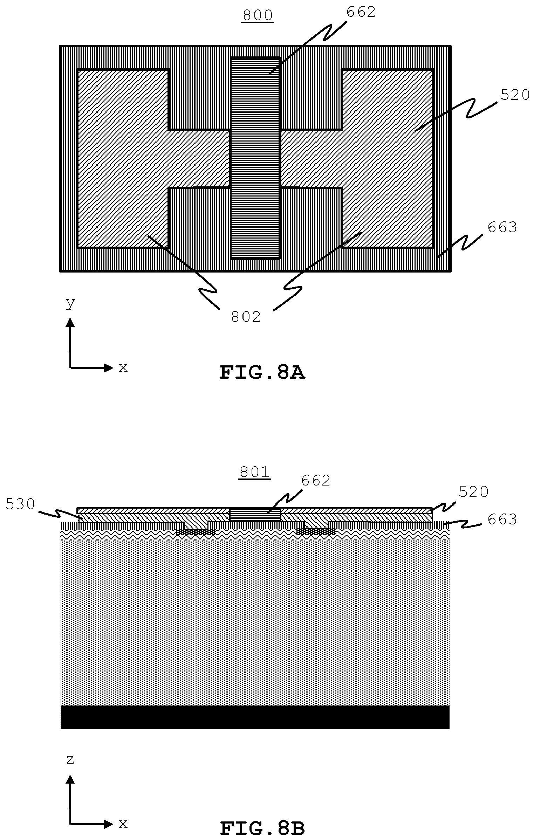

In an example embodiment, the first metallization layer may include a fourth area 524, which is typically located between the two first areas 522 of the bond pads. The fourth area may include a protective, non-conductive coating. Examples of DSN semiconductor device packages including such fourth area 524 are shown in Figs. 8A/8B, 9A/9B and 10A/10B.

As shown in Fig. 5, the bond pad 510 of the present disclosure, and in particular the second metallization layer 530 of the bond pad 510, extends further towards the semiconductor device 550 compared to bond pads in known DSN semiconductor device packages. In known DSN semiconductor device packages an ESD protection device is typically implemented in layers below and in between the terminal 102, 103 and the semiconductor device. The present disclosure extends the second metallization layer 530 towards the semiconductor device 550, allowing the ESD protection device to be limited in size or even removed.

It has been found that a rectangular shape of the third area 434, 534, extending from the center of the side of the second area 432, 532, such as shown in Fig. 4, has advantageous properties regarding capacitance and clamping voltages. I.e., the present disclosure reduces overall capacitance and improves clamping voltages.

In an example embodiment, the distance between the second metallization layer 530 and the semiconductor device 550, e.g., a P-type substrate in the second set of layers 552, may be 4 µm to 5 µm, or even larger than 5 µm. In another example embodiment, this distance may be increased by 7 µm or more by introducing further layers with, e.g., vias.

In an example embodiment, the thickness of the first metallization layer and the second metallization layer together may be about 8 µm.

It has been found that also the improved distance between the second metallization layer 530 and the semiconductor device 550 reduces the overall capacitance and improves clamping voltages.

Fig. 6 shows a legend indicating materials used in the examples of Figs. 7A-12B. The following materials are shown:

| | |
|---|---|
| 660a | Sn (in first metallization layer 520) |
| 660b | NiAu or NiPdAu (in first metallization layer 520) |
| 661 | Cu (in second metallization layer 530) |
| 662 | Protective coating, e.g., solder mask |
| 663 | Polyimide 1 |
| 664 | Polyimide 2 |
| 665 | Aluminum (Al) (device pad 542) |
| 666 | Oxide |
| 667 | Silicon (chip part, including semiconductor device 550) |
| 668 | Backside coating (optional) |

Fig. 7A shows a top view of an example DSN semiconductor device package 700, with two terminals 702, where the first metallization layer 520 may be similarly shaped as the second metallization layer 530. I.e., the second area 432, 532 and the third area 434, 534 of the second metallization layer 530 may be covered by the first area 422, 522 of the first metallization layer 520.

Fig. 7B shows a side cross-section view 701 of an example 1P1M (1 polysilicon and 1 metal) DSN semiconductor device package 700. In this example, the bond pad 510 may be created as CuSn metallization, indicating the metals used for the first 520 and second 530 metallization layers. The CuSn metallization in the first 520 and second 530 metallization layers are typically part of one metal mask. The Alternatively, the bond pad 520 may be created as CuNiAu or CuNiPdAu metallization.

Fig. 8A shows a top view of another example DSN semiconductor device package 800, with two terminals 802, where the first metallization layer 520 may be similarly shaped as the second metallization layer 530. I.e., the second area 432, 532 and the third area 434, 534 of the second metallization layer 530 may be covered by the first area 422, 522 of the first metallization layer 520. A protective, non-conductive coating 662 may be applied between the two terminals, e.g., using a solder mask. A small dam formed by the protective, non-conductive coating 662 may thus be present to minimize risk of soldering bridging.

Fig. 8B shows a side cross-section view 801 of an example 1P1M (1 polysilicon and 1 metal) DSN semiconductor device package 800 including protective coating 662. In this example, the bond pad 510 may be created as CuSn metallization, indicating the metals used for the first 520 and second 530 metallization layers. The CuSn metallization in the first 520 and second 530 metallization layers are typically part of one metal mask. Alternatively, the bond pad 520 may be created as CuNiAu or CuNiPdAu metallization.

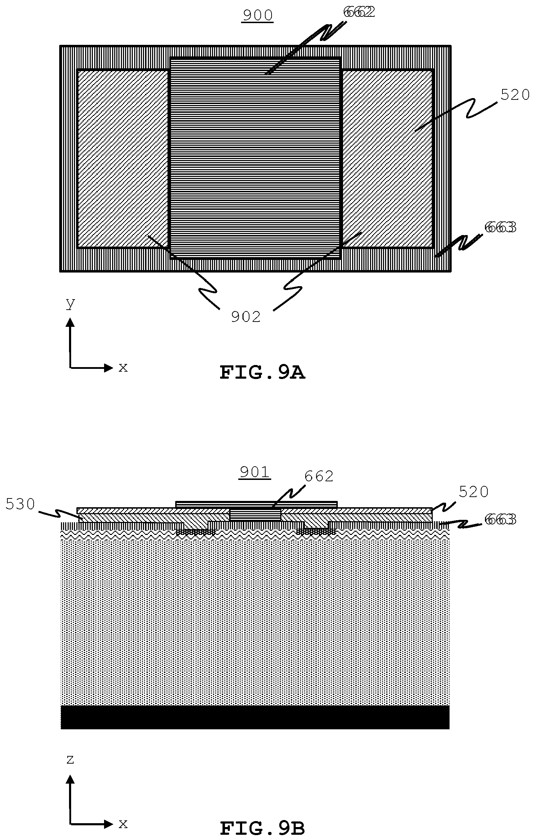

Fig. 9A shows a top view of another example DSN semiconductor device package 900, with two terminals 902. In this example, a protective, non-conductive coating 662 may be applied between and on top of the two terminals 902, e.g., using a solder mask. Compared to Fig. 8A, a larger dam formed by the protective, non-conductive coating 662 may thus be present to minimize risk of soldering bridging.

Fig. 9B shows a side cross-section view 901 of an example 1P1M (1 polysilicon and 1 metal) DSN semiconductor device package 900 including protective coating 662. In this example, the bond pad 510 is typically created as CuSn metallization, indicating the metals used for the first 520 and second 530 metallization layers. The CuSn metallization in the first 520 and second 530 metallization layers are typically part of one metal mask.

Fig. 10A shows a top view of another example DSN semiconductor device package 1000, with two terminals 1002. In this example, only the second area 432, 532 of the second metallization layer 530 may be covered by the first area 422, 522 of the first metallization layer 520. A protective, non-conductive coating 662 may be applied between the two terminals 1002, e.g., using a solder mask.

Fig. 10B shows a side cross-section view 1001 of an example 1P1M (1 polysilicon and 1 metal) DSN semiconductor device package 1000 including protective coating 662 between the terminals 1002. In this example, the bond pad 510 is typically created as CuNiAu or CuNiPdAu metallization, indicating the metals used for the first 520 and second 530 metallization layers. The protective coating 662 and the CuNiAu or CuNiPdAu metallization may be created using the same mask, with the protective coating acting as a mask for the metallization.

Fig. 11A shows a top view of another example DSN semiconductor device package 1100, with two terminals 1102. In this example, only the second area 432, 532 of the second metallization layer 530 may be covered by the first area 422, 522 of the first metallization layer 520. A protective, non-conductive coating 662 may be applied between and around the two terminals 1102, e.g., using a solder mask.

Fig. 11B shows a side cross-section view 1101 of an example 1P1M (1 polysilicon and 1 metal) DSN semiconductor device package 1100 including protective coating 662 all around the terminals 1102. In this example, the bond pad 510 is typically created as CuNiAu or CuNiPdAu metallization, indicating the metals used for the first 520 and second 530 metallization layers. The protective coating 662 and the CuNiAu or CuNiPdAu metallization may be created using the same mask, with the protective coating 662 acting as a mask for the metallization.

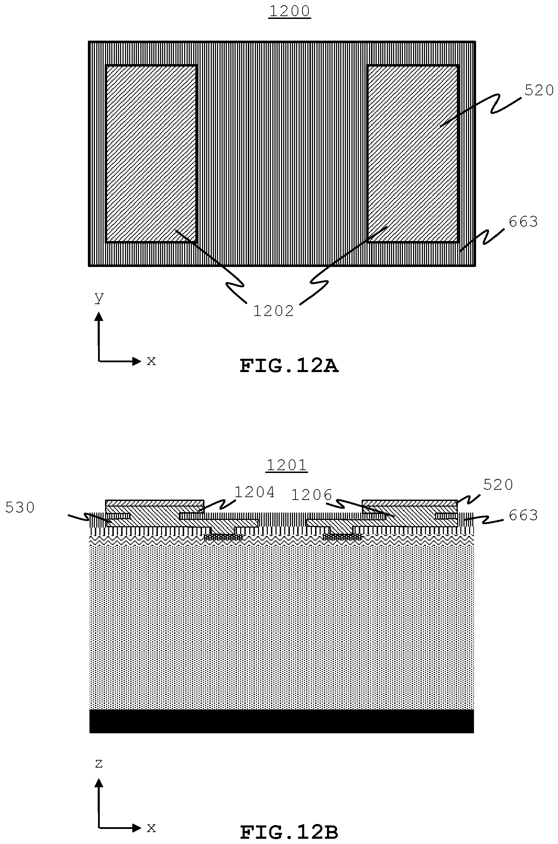

Fig. 12A shows a top view of another example DSN semiconductor device package 1200, with two terminals 1202. In this example, only the second area 432, 532 of the second metallization layer 530 may be covered by the first area 422, 522 of the first metallization layer 520.

Fig. 12B shows a side cross-section view 1201 of an example 2P2M (2 polysilicon and 2 metal) DSN semiconductor device package 1200. In this example additional metallization layers 1204, 1206 are included between the first metallization layer 520 and the second metallization layer 530, in the same metal 661 as the second metallization layer 530. In this example, the bond pad 510 is typically created as CuSn metallization, indicating the metals used for the first 520 and second 530 metallization layers. The two topmost metallization layers 520, 1204 of the bond pad 510 are typically part of one metal mask. The other metallization layers of the bond pad 510 may be part of another mask.

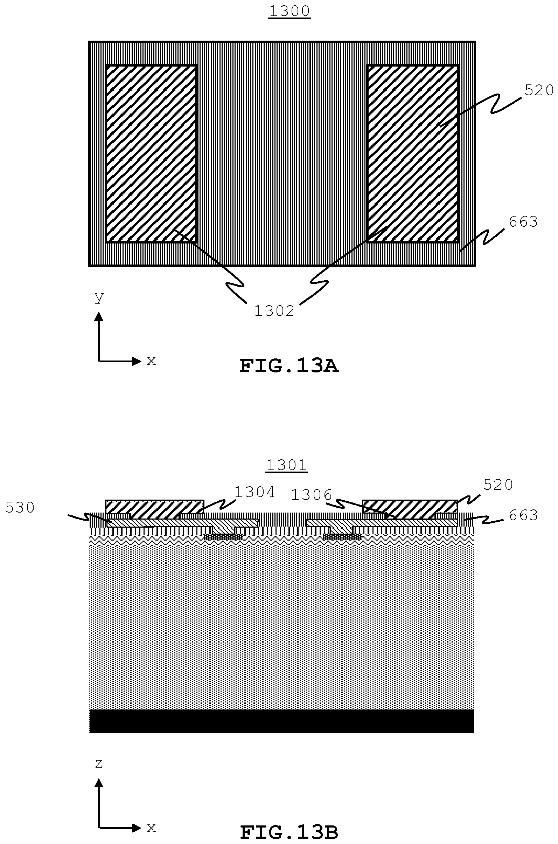

Fig. 13A shows a top view of another example DSN semiconductor device package 1300, with two terminals 1302. In this example, only the second area 432, 532 of the second metallization layer 530 may be covered by the first area 422, 522 of the first metallization layer 520.

Fig. 13B shows a side cross-section view 1301 of an example 2P2M (2 polysilicon and 2 metal) DSN semiconductor device package 1300. In this example additional metallization layers 1304, 1306 may be included between the first metallization layer 520 and the second metallization layer 530, in the same metal 660 as the first metallization layer 520. In this example, the bond pad 510 is typically created as CuNiAu or CuNiPdAu metallization, indicating the metals used for the first 520 and second 530 metallization layers.

The present disclosure is not limited to the examples shown in Figs. 7A-13B.

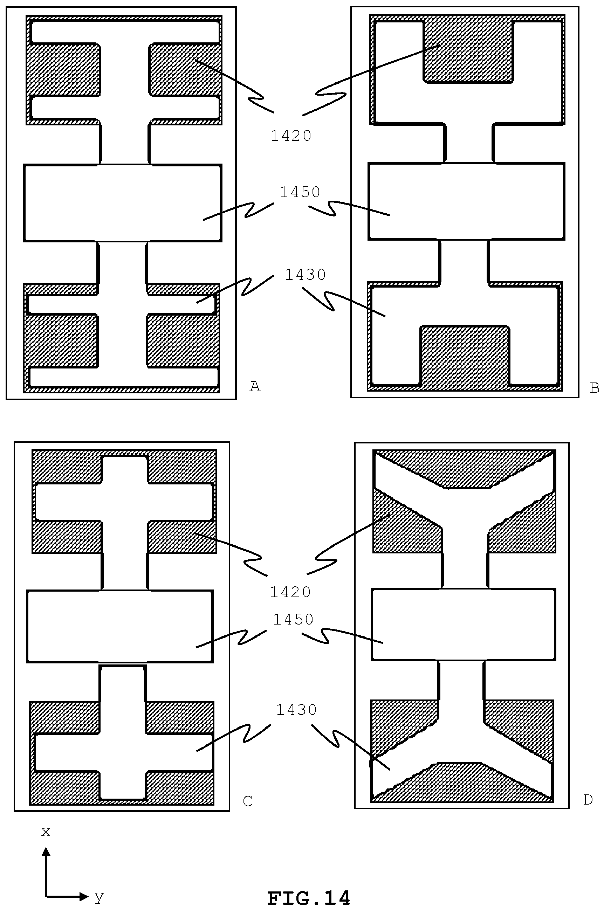

Figs. 14A-D show non-limiting examples of different shapes of a second metallization layer 1330 (which may be similar to second metallization layer 530) of the bond pads 510. In Figs. 14A-D the layers structure of the DSN semiconductor device package is not shown, i.e., first metallization layer 1420 (which may be similar to first metallization layer 520), second metallization layer 1430 and semiconductor device 1450 (which may be similar to semiconductor device 550) are shown in one plane, where in reality they are created in different layers, such as shown in the examples of 7A-12B.

Changing the layout of the second area 432, 532 of the second metallization layer 1430 from a rectangular layout, such as shown in Fig. 4, to a design consisting of horizontal, vertical and/or diagonal bar parts, such as shown in Fig. 14A-D, may enable further reduction in capacitance of the bond pads 510. By extending the bars to the edge of the solder land pad 1420 it may further be avoided that the device starts to tilt during soldering to a board.

As shown in the examples of Figs. 14A-D, the third area 434, 534 of the second metallization layer 1430 may extend to the edge of the semiconductor device 1450.

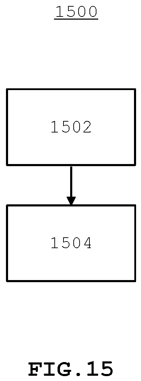

Fig. 15 shows steps of an example method of manufacturing a semiconductor device, such as a DSN semiconductor device, including a step 1502 of using a first mask to create the second metallization layer 530, 1330 and a step 1404 of using a second mask to create the first metallization layer 520, 1320, e.g., for creating CuNiAu or CuNiPdAu metallization. In an alternative embodiment, the first metallization layer and the second metallization layer may be created using a single mask, e.g., for creating CuSn metallization.

It will be understood that further manufacturing steps may be performed to create the full DSN semiconductor device package, as known per se.

## Claims

1. A dual silicone no-lead, DSN, semiconductor device package (300, 400) comprising a bond pad (510) defined by a first set of layers (512) and a semiconductor device (550, 1450) defined by a second set of layers (552), the bond pad providing a terminal (302) of the DSN semiconductor device package,
wherein the first set of layers comprises a first metallization layer (520, 1420) exposing the bond pad to the outside of the DSN semiconductor device package,
wherein the first metallization layer comprises a first area (422, 522) in the plane of the first metallization layer, wherein the first area at least comprises a rectangularly shaped area, and wherein the first area comprises a first metal (660),
wherein the first set of layers further comprises a second metallization layer (530, 1430) conductively connected to the first metallization layer, wherein the second metallization layer comprises a second area (432, 532) in the plane of the second metallization layer, wherein the second area is positioned below the first area, and wherein the second area comprises a second metal (661),
and wherein the second metallization layer further comprises a third area (434, 534) in the plane of the second metallization layer, wherein the third area is rectangularly shaped and extends from one side of the second area towards a location above the semiconductor device, wherein the width of the third area where the third area touches the one side of the second area is smaller than the length of the one side of the second area, and wherein the third area comprises the second metal.

2. The DSN semiconductor device package (700, 800, 900) according to claim 1, wherein the second area and the third area are fully covered by the first area.

3. The DSN semiconductor device package (1000, 1100, 1200, 1300) according to claim 1, wherein the second area is fully covered by the first area, and wherein the third area is not covered by the first area.

4. The DSN semiconductor device package according to any one of the preceding claims, wherein the first set of layers further comprises a third metallization layer (540) providing a via between the third area of the second metallization layer and a device pad (542) of the semiconductor device, wherein the via comprises the second metal.

5. The DSN semiconductor device package according to any one of the preceding claims, wherein the first metal is one of: tin, Sn; nickel/gold alloy, NiAu; and nickel/palladium/gold alloy, NiPdAu.

6. The DSN semiconductor device package according to any one of the preceding claims, wherein the second metal is copper, Cu.

7. The DSN semiconductor device package according to any one of the preceding claims, wherein the width of the third area is about one third of the length of the one side of the second area.

8. The DSN semiconductor device package according to any one of the preceding claims, wherein the third area extends from the middle of the one side of the second area to above an edge of the semiconductor device.

9. The DSN semiconductor device package (700, 800, 900, 1000, 1100) according to any one of the claims 1-8, wherein the second metallization layer is directly below the first metallization layer.

10. The DSN semiconductor device package (1200, 1300) according to any one of the claims 1-8, wherein the first set of layers comprises one or more further metallization layers between and conductively connecting the first metallization layer and the second metallization layer.

11. The DSN semiconductor device package according to any one of the preceding claims, comprising two similarly shaped bond pads each formed as the bond pad, wherein the bond pads are positioned in a mirrored orientation, such that the third area of each of the bond pads extends towards the location above the semiconductor device.

12. The DSN semiconductor device package according to claim 11, wherein the first metallization layer further comprises a fourth area (524) between the first areas of the bond pads, wherein the fourth area comprises a protective, non-conductive coating (662).

13. The semiconductor device package according to any one of the preceding claims, wherein the semiconductor device package is a dual silicone no-lead, DSN, semiconductor device package.

14. A method (1500) of manufacturing a dual silicone no-lead, DSN, semiconductor device package comprising a bond pad defined by a first set of layers and a semiconductor device defined by a second set of layers, the bond pad providing a terminal of the DSN semiconductor device package, the method comprising:
creating (1502, 1504) a second metallization layer of the first set of layers; and
creating (1502, 1504) a first metallization of the first set of layers,
wherein the first set of layers comprises a first metallization layer exposing the bond pad to the outside of the DSN semiconductor device package,
wherein the first metallization layer comprises a first area in the plane of the first metallization layer, wherein the first area at least comprises a rectangularly shaped area, and wherein the first area comprises a first metal,
wherein the first set of layers further comprises a second metallization layer conductively connected to the first metallization layer, wherein the second metallization layer comprises a second area in the plane of the second metallization layer, wherein the second area is positioned below the first area, and wherein the second area comprises a second metal,
and wherein the second metallization layer further comprises a third area in the plane of the second metallization layer, wherein the third area is rectangularly shaped and extends from one side of the second area towards a location above the semiconductor device, wherein the width of the third area where the third area touches the one side of the second area is smaller than the length of the one side of the second area, and wherein the third area comprises the second metal.

15. The method according to claim 14, wherein creating two similarly shaped bond pads each formed as the bond pad, wherein the bond pads are positioned in a mirrored orientation, the third area of each of the bond pads extending towards the location above the semiconductor device.
